Europäisches Patentamt

European Patent Office

Office européen des brevets

(19)

(11) Numéro de publication : **0 226 490 B1**

(12) **FASCICULE DE BREVET EUROPEEN**

(45) Date de publication du fascicule du brevet :
**23.01.91 Bulletin 91/04**

(51) Int. Cl.$^5$ : **H03H 19/00**

(21) Numéro de dépôt : **86402482.3**

(22) Date de dépôt : **06.11.86**

(54) **Filtre synchrone à capacités commutées.**

(30) Priorité : **13.11.85 FR 8516745**

(43) Date de publication de la demande :
**24.06.87 Bulletin 87/26**

(45) Mention de la délivrance du brevet :
**23.01.91 Bulletin 91/04**

(84) Etats contractants désignés :
**DE GB NL**

(56) Documents cités :
**GB-A- 1 400 515**
**US-A- 3 793 599**
**ELECTRONICS LETTERS, vol. 15, no. 16, 2**
**août 1979, pages 486-487, Londres, GB; B.**
**PAIN: "Some comments on notch capability of**
**N-path filters"**

(73) Titulaire : **COMMISSARIAT A L'ENERGIE**
**ATOMIQUE Etablissement de Caractère**
**Scientifique Technique et Industriel**
**31/33, rue de la Fédération**
**F-75015 Paris (FR)**

(72) Inventeur : **Gignoux, Michel**
**La Charrière Froide**
**F-38760 Saint Paul de Varces (FR)**

(74) Mandataire : **Mongrédien, André et al**
**c/o BREVATOME 25, rue de Ponthieu**
**F-75008 Paris (FR)**

## Description

La présente invention concerne un filtre synchrone à capacités commutées.

Elle s'applique au filtrage d'un signal présentant une composante utile associée à un bruit de fond important.

Le filtre de l'invention est un filtre de type passe-bande, à bande étroite centrée sur la fréquence de la composante utile du signal d'entrée. La fréquence centrale de sa bande passante est déterminée par la fréquence des impulsions d'horloge commandant la commutation des capacités. Ce filtre comporte N paires de voies, chaque voie comprenant au moins une capacité à commuter.

L'invention s'applique à la sélection d'un signal périodique mélangé à un autre signal, à l'analyse harmonique, aux télécommunications, au traitement du signal en résonance magnétique nucléaire, aux asservissements, etc...

On sait que des filtres passe bandes très sélectifs peuvent être réalisés très facilement en utilisant des structures dites à N chemins commutés, comprenant chacun une résistance associée à un condensateur et à des commutateurs, comme on le verra plus loin en détail ; ces structures peuvent être réduites à un circuit équivalent à N chemins, dans lequel chaque chemin comprend au moins un condensateur, associé à deux commutateurs, l'ensemble des chemins étant relié à une résistance commune d'entrée. Ce circuit équivalent est souvent qualifié de filtre à N chemins, à commutation de capacités. Ce type de filtre a pour principal avantage de présenter une réponse en "peigne", de présenter une bande passante de largeur réglable et d'être accordable en fréquence grâce aux impulsions d'une horloge étalon externe. Cette dernière propriété permet, en technologie micro-électronique, de réaliser des filtres dont la structure est intégrable. Les filtres à étalons de fréquences externes sont beaucoup moins sensibles que les autres filtres, aux variations des valeurs des éléments qui les constituent. Le réglage externe de leur fréquence d'accord, ainsi que leur synchronisation par un signal extérieur, sont réalisés simplement. La fréquence centrale de la dent principale de la courbe de réponse de ces filtres en "peigne", est définie par la fréquence des impulsions de l'horloge externe.

L'obtention d'une bande passante très étroite avec un filtre de ce type, nécessite un accroissement du nombre N des chemins du filtre ; l'augmentation du nombre des chemins d'un filtre en "peigne" conduit simultanément à augmenter la fréquence de l'horloge de commande externe, ce qui pour une technologie donnée, peut aboutir à limiter la fréquence haute du filtre.

Il résulte de ces observations qu'un filtre à commutation présente une bande passante dont la finesse est limitée par la fréquence des signaux de commutation.

Un but également recherché dans les filtres, est de rejeter tout signal parasite, sans pour autant apporter de déphasage entre le signal d'entrée de ce filtre et le signal de sortie de celui-ci.

La plupart des filtres connus dans l'état de la technique, introduisent un déphasage entre le signal d'entrée et le signal de sortie. Il existe cependant des filtres à capacités commutées, dits synchrones, dans lesquels la synchronisation est définie par la fréquence des impulsions de l'horloge de commande des commutations des chemins du filtre. Ces filtres connus dans l'état de la technique sont notamment décrits dans la revue IEEE JOURNAL OF SOLID STATE CIRCUITS – volume SC18 – n°6, décembre 1983, pages 753 à 761 ; ils ont pour principale caractéristique de ne pas comporter une seule, mais une pluralité de bandes passantes, ce qui pour certaines applications est très gênant. En effet, si l'une des bandes passantes se trouve centrée sur un signal parasite, celui-ci est transmis, ce qui peut être très préjudiciable à certaines applications. Les filtres synchrones n'ont pas la même largeur équivalente de bande passante, vis-à-vis d'un signal périodique et d'un signal aléatoire. Cela est clairement indiqué dans le livre de Robert Miquel, intitulé "Le filtrage numérique", éditions Editests, (février 1985), page 143.

Il est souvent utile dans le filtrage synchrone, d'obtenir une absence de réponse du filtre, à une fréquence nulle et aux harmoniques paires du signal d'entrée. Il est utile également d'obtenir une atténuation importante des harmoniques impaires. Les filtres synchrones à commutation connus ne permettent malheureusement pas de répondre à toutes ces contraintes.

Des filtres connus qui permettent de répondre partiellement aux contraintes de phase, d'élimination des harmoniques paires, d'atténuation des harmoniques impaires et d'élimination de signal parasite, sont décrits dans différentes revues :

– la revue AEG-BAND 25, 1971, HEFT4, pages 173 à 180, décrit des filtres à commutation à N chemins, de type "stop-go". Ce type de filtre a pour principal inconvénient de présenter plusieurs bandes passantes et de ne pas permettre l'obtention d'un signal filtré en phase avec le signal d'entrée ;

– la revue IEEE JOURNAL OF SOLID STATE CIRCUITS, volume SC15, n°3, juin 1980, pages 301 à 305, décrit un filtre synchrone à commutation, utilisant des capacités commutées, mais dont la structure ne permet pas de répondre aux impératifs de phase et d'élimination des harmoniques ;

– la revue IEEE TRANSACTIONS ON CIRCUITS AND SYSTEMS, volume CAS29, n°8, août 1982, pages 557 à 572, décrit un filtre à commutation à N chemins, à capacités commutées. Cette revue fait apparaitre notamment les défauts mentionnés plus haut, pour ce type de filtre.

La présente invention a pour but de remédier aux inconvénients des filtres à commutation, notamment à N chemins, et à certains inconvénients des filtres utilisant des capacités commutées. Elle a pour but de réaliser un filtre à N paires de voies, chaque voie comportant au moins une capacité de commutation, ces N paires de voies étant reliées en parallèle ; il permet d'éliminer les harmoniques paires du signal d'entrée, d'atténuer les harmoniques impaires avec une loi d'affaiblissement plus importante que dans les filtres à N chemins ou à détection synchrone. De plus, il peut présenter une absence de réponse en présence de signal d'entrée, à fréquence nulle. Enfin, il permet d'échantillonner un signal d'entrée de période T à la fréquence limite de SHANNON qui est $\frac{1}{2T}$. Il permet de ne pas utiliser de dispositif anti-repliement, ce qui n'est pas le cas des filtres à échantillonnage qui souvent exigent à leur entrée un dispositif anti-repliement du spectre d'entrée sur lui-même, et à leur sortie un dispositif de restitution.

L'invention a pour objet un filtre synchrone à capacités commutées de filtrage reliées en parallèle, comprenant des moyens adaptateurs recevant sur une entrée, un signal à filtrer, de période T et fournissant ce signal sur une sortie reliée à des entrées de chemins de filtrage au nombre de N, ces chemins de filtrage comportant respectivement des moyens de filtrage à capacités commutées, ce filtre comprenant en outre des moyens de commutation des moyens de filtrage, reliés à ces moyens de filtrage, des moyens sommateurs ayant des entrées respectivement reliées à des sorties des moyens de filtrage de chaque chemin pour fournir le signal filtré sur une sortie, et des moyens d'échantillonnage reliés aux moyens de commutation pour leur appliquer des signaux de commande de commutation des moyens de filtrage, caractérisé en ce que les moyens de filtrage de chaque chemin comportent deux voies identiques de filtrage par capacité, reliées aux moyens de commutation, les signaux de commande de commutation étant symétriques pour les deux voies de chaque chemin, ces signaux étant déphasés de $\frac{T}{2N}$ entre deux chemins successifs et ayant respectivement des périodes d'échantillonnage des deux voies d'un chemin, égales à $\frac{T}{2}$.

Selon une autre caractéristique de l'invention, les deux voies de filtrage de chaque chemin comprennent une résistance commune dont une borne est reliée à la sortie des moyens adaptateurs, les moyens de commutation comprenant un premier et un deuxième commutateurs à deux positions, chacune de ces voies comprenant un condensateur dont une électrode est reliée à une masse de référence, une autre électrode du condensateur d'une première des deux voies étant reliée à une première borne du premier commutateur à deux positions et à une première borne du deuxième commutateur à deux positions, une autre électrode du condensateur d'une deuxième des deux voies étant reliée à une deuxième borne du premier commutateur et à une deuxième borne du deuxième commutateur, une borne commune aux deux positions du premier commutateur étant reliée à une autre borne de la résistance commune et une borne commune aux deux positions du premier commutateur étant reliée à une entrée correspondante des moyens sommateurs, les commutateurs ayant des entrées de commande reliées aux moyens d'échantillonnage pour recevoir lesdits signaux de commande.

Selon une autre caractéristique, les deux voies de filtrage de chaque chemin comprennent une résistance commune dont une borne est reliée à la sortie des moyens adaptateurs, les deux voies de filtrage comprenant un condensateur tournant à deux électrodes, au cours de la rotation du condensateur, une première électrode est reliée à une autre borne de la résistance commune et à une entrée correspondante des moyens sommateurs, et une deuxième électrode est reliée à une masse de référence, la rotation provoquant ensuite une commutation de ces électrodes pour relier la deuxième électrode avec l'autre borne de la résistance et l'entrée correspondante des moyens sommateurs, et pour relier la première électrode avec la masse de référence, les moyens de commutation comportant des moyens de commande de rotation des condensateurs tournants ayant des entrées de commande reliées aux moyens d'échantillonnage pour recevoir lesdits signaux de commande.

Selon une autre caractéristique, les deux voies de filtrage de chaque chemin comprennent un amplificateur opérationnel commun à ces deux voies dont une première entrée est reliée à l'autre borne de la résistance commune et dont une deuxième entrée est reliée à une masse de référence, une sortie de cet amplificateur opérationnel étant reliée à une entrée correspondante des moyens sommateurs, et un condensateur tournant à deux électrodes, au cours de la rotation du condensateur, une première électrode est reliée à la première entrée de l'amplificateur opérationnel et une deuxième électrode est reliée à la sortie de l'amplificateur, la rotation provoquant ensuite une commutation de ces électrodes pour relier la deuxième électrode à la première entrée de l'amplificateur et la première électrode à la sortie de l'amplificateur, les moyens de commutation comportant des moyens de commande de rotation des condensateurs tournants ayant des entrées de commande reliées aux moyens d'échantillonnage pour recevoir lesdits signaux de commande.

Selon une autre caractéristique, la résistance commune est une résistance pure.

Selon une autre caractéristique, la résistance commune est une résistance simulée par commutation de capacité.

Selon une autre caractéristique, la capacité commutée est un condensateur tournant à une fréquence supérieure à la fréquence des signaux de commande de commutation des chemins.

Les caractéristiques et avantages de l'invention ressortiront mieux de la description qui va suivre, donnée en référence aux dessins annexés dans lesquels:

– la figure 1 représente schématiquement, un filtre à n chemins commutés, conforme à l'invention,

– la figure 2 est un chronogramme des signaux de commande de commutation des chemins et voies du filtre de la figure 1,

– la figure 3 représente schématiquement, un premier mode de réalisation d'un filtre conforme à l'invention,

– la figure 4 représente schématiquement un deuxième mode de réalisation d'un filtre conforme à l'invention,

– la figure 5 représente schématiquement un troisième mode de réalisation d'un filtre conforme à l'invention,

– la figure 6 représente schématiquement un autre mode de réalisation d'une résistance de filtrage intervenant dans chacun des chemins du filtre de l'invention.

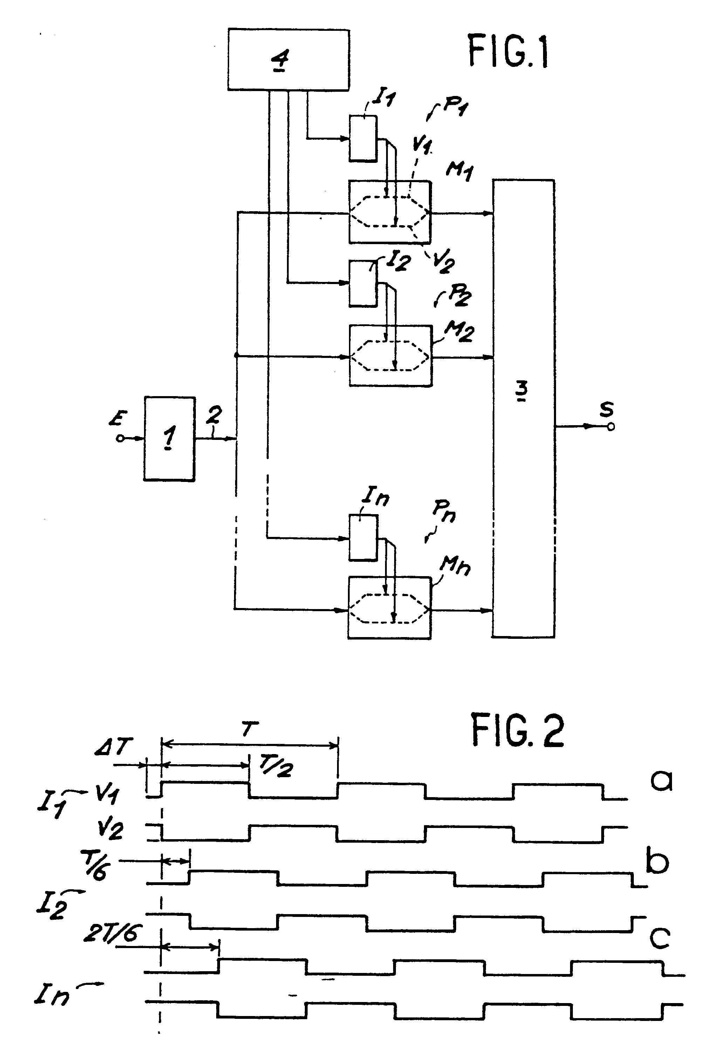

La figure 1 représente schématiquement un filtre à N paires de voies reliées en parallèle, conforme à l'invention. Le filtre comprend des moyens adaptateurs 1, qui peuvent être constitués, comme on le verra plus loin en détail par un amplificateur adaptateur d'impédance ; ces moyens reçoivent sur une entrée E, un signal à filtrer, de période T, de type sinusoïdal par exemple. Ce signal est appliqué simultanément par une sortie 2 de l'adaptateur 1, à des entrées de chemins de filtrage $P_1$, $P_2$, ..., $P_n$. Ces chemins de filtrage comportent des paires de voies de filtrage $M_1$, $M_2$, ..., $M_n$, qui seront décrites plus loin en détail. Il comprend aussi des moyens de commutation $I_1$, $I_2$, ..., $I_n$ des voies, reliés à ces voies. Des moyens sommateurs 3 sont reliés simultanément à des sorties des chemins pour fournir sur une sortie S, le signal filtré. Le filtre comprend aussi des moyens d'échantillonnage 4, reliés aux moyens de commutation $I_1$, $I_2$, ..., $I_n$, pour leur appliquer des signaux de commande de commutation des voies, qui seront décrits plus loin en détail.

Les voies de filtrage $M_1$, $M_2$, ..., $M_n$ de chaque chemin sont formées de deux voies identiques $V_1$, $V_2$ de filtrage, reliées aux moyens de commutation correspondants. Comme on le verra plus loin, les signaux de commande de commutation des voies, fournis par les moyens d'échantillonnage 4, sont des signaux respectivement symétriques pour les deux voies de chaque chemin. Ces signaux sont déphasés de $\frac{T}{2N}$, entre deux chemins successifs, les périodes d'échantillonnage des deux voies étant égales à $\frac{T}{2}$.

On a limité à 3 le nombre des chemins représentés sur cette figure, pour en faciliter la compréhension.

La figure 2 est un chronogramme des signaux d'échantillonnage ou de commande de commutation des voies du filtre de la figure 2. Ces signaux sont fournis par les moyens d'échantillonnage 4 et sont appliqués aux moyens de commutation $I_1$, $I_2$, ..., $I_n$, pour commander la commutation des voies de chaque chemin. Si le signal périodique d'entrée du filtre a pour période T, la période d'échantillonnage de chaque voie d'un chemin est égale à $\frac{T}{2}$. Le diagramme (a) représente sur la figure 2, les signaux de commande de commutation appliqués à chacune des voies $V_1$, $V_2$ du filtre, par les moyens de commutation $I_1$, commandés par les moyens d'échantillonnage 4. Les diagrammes (b) et (c) représentent respectivement les signaux de commande de commutation appliqués aux deux voies du chemin $P_2$ par les moyens de commande $I_2$, et aux deux voies du chemin $P_N$, par les moyens de commande $I_n$. On voit sur cette figure que les signaux de commande de commutation des deux voies d'un même chemin sont symétriques ; ces signaux sont décalés de $\frac{T}{2N}$ entre deux chemins successifs. Dans l'exemple représenté sur cette figure, le filtre comprenant trois chemins à deux voies, les signaux de commande de commutation des chemins $P_2$ et $P_n$ sont respectivement déphasés de $\frac{T}{6}$ et $\frac{2T}{6}$ par rapport aux signaux de commande de commutation des voies du chemin $P_1$.

Ces signaux peuvent être déphasés ou non par rapport au signal à filtrer. l'exemple représenté sur la figure, on suppose que ces signaux sont déphasés de $\Delta T$, par rapport au signal à filtrer. Malgré ce déphasage, le signal en sortie est en phase avec le signal d'entrée.

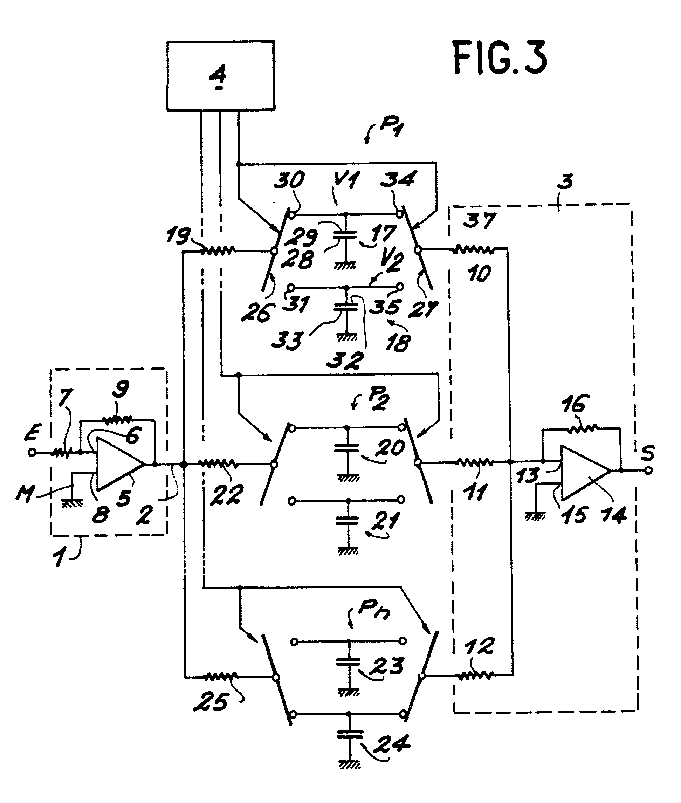

La figure 3 représente un premier mode de réalisation d'un filtre conforme à l'invention. Les mêmes éléments portent les mêmes références sur cette figure et sur la figure 1. Les moyens adaptateurs 1 sont représentés ici de manière plus détaillée. Ils peuvent être constitués par exemple, par un amplificateur opérationnel recevant le signal à filtrer sur une entrée 6, par l'intermédiaire d'une résistance 7. Une autre entrée 8 de cet amplificateur opérationnel est reliée à une masse de référence M. L'entrée 6 et la sortie 2 de cet amplificateur, sont reliées par une résistance 9. Ce montage adaptateur est connu dans l'état de la technique et son fonctionnement ne sera pas expliqué ici de manière plus détaillée. E désigne l'entrée du filtre.

Les moyens sommateurs 3 ont des entrées qui sont reliées aux sorties des chemins à deux voies $P_1$, $P_2$, ..., $P_n$ ; ces moyens sommateurs sont constitués par exemple par des résistances 10, 11, 12 reliées respectivement aux sorties des chemins. Toutes ces résistances présentent une même valeur et sont reliées à une entrée 13 d'un amplificateur opérationnel 14. Une autre entrée 15 de cet amplificateur opérationnel est reliée à la masse de référence. Les moyens addtionneurs comportent aussi, de manière connue, une résistance 16 reliée à l'entrée 13 de l'amplificateur et à la sortie S. Les voies de filtrage $V_1$, $V_2$ de chaque chemin comprennent respectivement, des condensateurs 17, 18 et une résistance commune 19, tel que représenté sur la figure, pour les voies $V_1$, $V_2$ du chemin $P_1$. De la même manière, le chemin $P_2$ comporte deux voies de filtrage constituées par les condensateurs 20, 21 et la résistance commune 22 ; le chemin $P_n$ comprend lui aussi deux voies de filtrage constituées par les condensateurs 23, 24 et par la résistance commune 25. Une borne de chaque résistance commune est reliée à la sortie 2 des moyens adaptateurs et toutes les résistances communes ont la même valeur. Dans ce mode de réalisation, les moyens de commutation comprennent pour chacun des chemins, un premier et un deuxième commutateurs à deux positions. C'est ainsi par exemple que pour le chemin $P_1$, le premier commutateur est représenté en 26 tandis que le deuxième commutateur est représenté en 27. Dans chacune des voies, chaque condensateur tel que 17 par exemple, comprend une électrode 28 qui est reliée à la masse de référence. Une autre électrode 29 de ce condensateur, pour la première voie, est reliée à une première borne 30 du premier commutateur 26 à deux positions. De la même manière pour la deuxième voie $V_2$, une électrode 33 du condensateur 18, est reliée à la masse de référence, tandis qu'une autre électrode 32 de ce condensateur est reliée à une deuxième borne 31 du premier commutateur 26. L'électrode 29 du condensateur 17 est aussi reliée à une première borne 34 du deuxième commutateur 27 à deux positions, et l'électrode 32 du condensateur 18, est reliée à une deuxième borne 35 de ce deuxième commutateur 27. Une borne commune 36 du premier commutateur 26 est reliée à une autre borne de la résistance commune 19, tandis qu'une borne commune 37 du deuxième commutateur 27, est reliée à la résistance correspondante 10, des moyens sommateurs 3. Ces commutateurs, qui peuvent être par exemple de type électronique, présentent des entrées de commande reliées à des sorties correspondantes des moyens d'échantillonnage 4, pour recevoir les signaux de commande qui ont été décrits plus haut. Les autres chemins $P_2$, $P_n$ représentés sur cette figure, sont constitués de manière identique et ne seront pas décrits en détail. Les premier et deuxième commutateurs des voies dans chaque chemin, ont un fonctionnement exclusif : si le premier commutateur est fermé dans sa première position 30, le deuxième commutateur est lui aussi fermé dans sa première position 34. De la même manière, si le premier commutateur est fermé dans sa deuxième position 33, le deuxième commutateur est lui aussi fermé dans sa deuxième position 35.

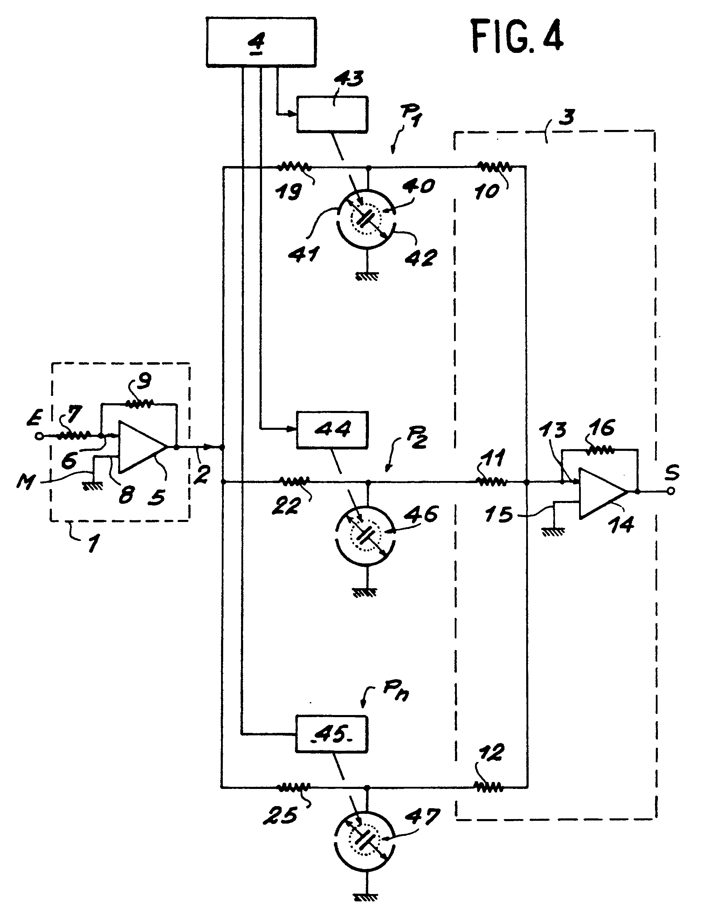

La figure 4 représente schématiquement un deuxième mode de réalisation d'un filtre conforme à l'invention. Les mêmes éléments portent les mêmes références sur cette figure et sur la figure 3. Dans ce mode de réalisation, les moyens adaptateurs 1 et les moyens sommateurs 3, sont identiques à ceux de la figure 2. Chaque chemin $P_1$ ou $P_2$, ... ou $P_n$ comporte deux voies de commutation comprenant respectivement une résistance commune reliée à un condensateur dit "tournant", tel que le condensateur 40 par exemple, qui comprend deux électrodes 41, 42. Chacune des voies est définie par une des deux positions du condensateur correspondant. Chaque résistance commune présente une borne qui est reliée à la sortie 2 des moyens adaptateurs 1. Au cours de la rotation du condensateur 40, une première électrode 41 du condensateur 40, est reliée à une autre borne de la résistance commune 19, ainsi qu'à une entrée correspondante des moyens sommateurs 3. Cette entrée, dans l'exemple de réalisation représenté sur la figure est l'une des bornes de la résistance 10. Une deuxième électrode 42 du condensateur 40 est reliée à la masse de référence. La rotation du condensateur provoque ensuite une commutation des électrodes 41, 42, de sorte que la deuxième électrode 42 est alors reliée à l'autre borne de la résistance commune 19 et l'entrée correspondante des moyens sommateurs 3, et de sorte que la première électrode 41 est alors reliée à la masse de référence. Les moyens de commutation, pour les chemins $P_1$, $P_2$, $P_n$ pour ce deuxième mode de réalisation, sont respectivement constitués par des moyens 43, 44, 45 de commande de rotation des condensateurs tournants 40, 46, 47. Ces moyens de commande de rotation reçoivent les signaux de commande de commutation décrits plus haut, fournis par les moyens d'échantillonnage 4. Dans ce mode de réalisation, chaque électrode de condensateur tournant est alternativement commutée d'une borne de la résistance commune 19, à la masse de référence. Cette masse de référence peut d'ailleurs être un potentiel non nul, pourvu que ce soit le même que le potentiel de référence de l'amplificateur 5.

La "rotation" de chaque condensateur tournant est en fait une représentation imagée du fonctionnement de ce condensateur. En fait les électrodes ou plaques du condensateur peuvent être fixes et la "rotation" est assimilable à une commutation des électrodes ou plaques du condensateur.

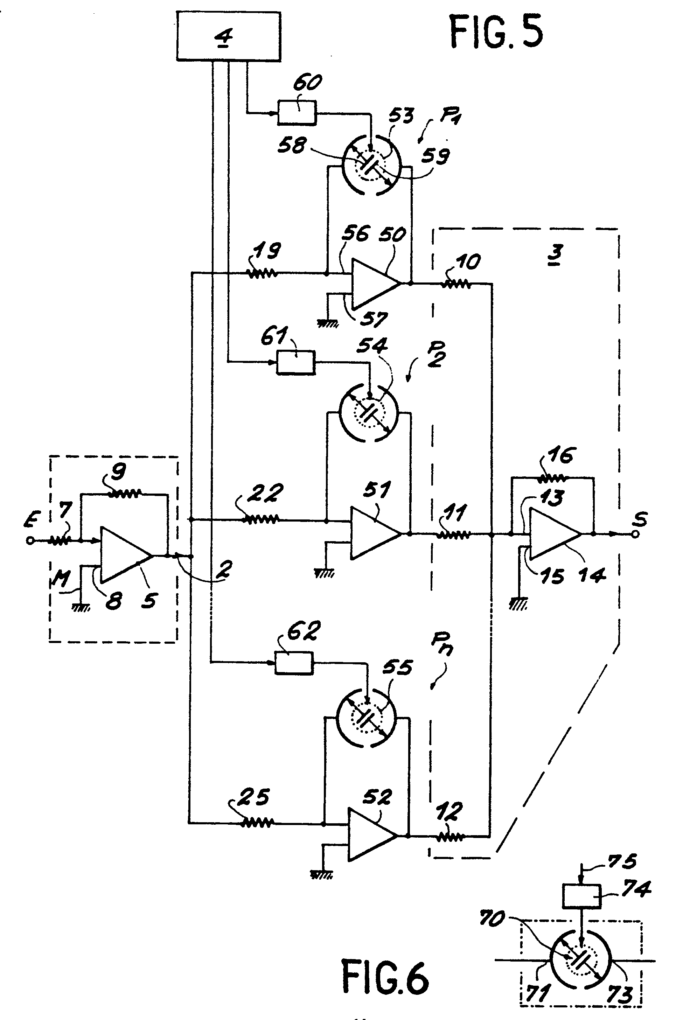

La figure 5 représente schématiquement un troisième mode de réalisation d'un filtre conforme à l'invention.

Les mêmes éléments portent les mêmes références sur cette figure et sur les figures 3 et 4. Les moyens adaptateurs 1 et les moyens sommateurs 3, qui ont déjà été décrits, ne seront pas décrits de nouveau en détail. Chacun des chemins $P_1$, $P_2$, ..., $P_n$ comprend ici aussi deux voies de filtrage qui, pour chaque chemin, comportent une résistance commune. Ces résistances communes sont représentées sur la figure en 19, 22, 25. Les deux voies de filtrage du chemin $P_1$ par exemple, comportent un amplificateur opérationnel dont la sortie est reliée à l'une des entrées par un condensateur tournant. L'une des deux positions du condensateur définit une voie de filtrage. Les amplificateurs opérationnels pour les voies de filtrage du mode de réalisation représenté sur cette figure, sont référencés 50, 51, 52, tandis que les condensateurs tournants qui leur sont associés, sont référencés 53, 54, 55. Comme dans les modes de réalisation précédents, les résistances communes 19, 22, 25 comprennent une borne qui est reliée à la sortie de l'adaptateur 1. Chacune des résistances, telle que la résistance 19 par exemple, comprend une autre borne qui est reliée à une première entrée 56 de l'amplificateur opérationnel correspondant 50. Une deuxième entrée 57 de cet amplificateur opérationnel est reliée à une masse de référence. La sortie de cet amplificateur est reliée à l'une des entrées des moyens sommateurs 3 (l'une des bornes de la résistance 10). Les condensateurs tournants 53, 54, 55 forment, avec les résistances communes 19, 22, 25 correspondantes, les deux voies de filtrage de chaque chemin. Au cours de la rotation du condensateur 53 par exemple, une première électrode 58 de ce condensateur est reliée à la première entrée 56 de l'amplificateur opérationnel 50, tandis qu'une deuxième électrode 59 de ce condensateur, est reliée à la sortie de cet amplificateur. La rotation du condensateur provoque ensuite une commutation de ces électrodes, pour relier la deuxième électrode 59 à la première entrée 56 de l'amplificateur opérationnel, et pour relier la première électrode 58 à la sortie de cet amplificateur 50. Comme dans le deuxième mode de réalisation, les moyens de commutation peuvent être constitués ici par des moyens de commande 60, 61, 62 de la rotation des condensateurs tournants 53, 54, 55. Ces moyens de commande ont des entrées qui sont reliées aux moyens d'échantillonnage 4, pour recevoir les signaux de commande de commutation décrits plus haut.

Comme dans le mode de réalisation précédent, les électrodes des condensateurs tournants sont commutées alternativement entre la première entrée de l'amplificateur opérationnel correspondant, et la sortie de celui-ci.

Dans les modes de réalisation représentés sur les figures 3, 4, 5, on a supposé que les résistances communes 19, 22, 25 étaient des résistances pures.

La figure 6 représente schématiquement un autre mode de réalisation des résistances communes de filtrage 19, 22, 25 intervenant dans chacun des chemins du filtre de l'invention.

Il est possible en effet, dans les modes de réalisation précédents, de remplacer les résistances communes 19, 22, 25 respectivement par des montages dits de résistances simulées par condensateurs; l'un de ces montages est représenté sur la figure 6. Dans ce montage, la résistance commune est simulée par un condensateur tournant 70. L'une des bornes 71 est reliée à la sortie 2 des moyens adaptateurs 1, tandis que l'autre borne 73 est reliée au point commun aux deux voies de chaque chemin. Ce point commun peut être soit la borne commune de l'un des premiers commutateurs de la figure 3, soit l'une des deux parties de la "carcasse" ou des plaques des condensateurs correspondants, dans le deuxième mode de réalisation de la figure 4, soit l'entrée de l'amplificateur opérationnel correspondant, dans le mode de réalisation de la figure 5. La commutation du condensateur est commandée par des moyens de commande 74 recevant des signaux d'échantillonnage ou de commande de commutation, sur une entrée 75. Le fonctionnement de ces condensateurs simulant une résistance, est bien connu dans l'état de la technique et ne sera pas décrit ici en détail. Il est évident que d'autres moyens de simulation de résistances pourraient être envisagés. Les signaux d'échantillonnage appliqués sur l'entrée 75 permettent de simuler une résistance par un condensateur. Ces signaux peuvent être fournis par les moyens d'échantillonnage 4. La fréquence de ces siganux est cependant plus élevée que celle qui permet de commander les commutations des voies et des chemins de filtre.

Dans tous les modes de réalisation qui viennent d'être décrits, chacun des filtres élémentaires à deux voies constitue en fait un échantillonneur moyenneur à deux voies qui agit en deux temps : chaque filtre élémentaire est échantillonné à la même fréquence, mais avec une phase différente dépendant du nombre de chemins, comme on l'a indiqué plus haut. Toutes les constantes de temps sont en principe égales. Dans les modes de réalisation qui utilisent une résistance commune pure et un condensateur tournant constituant les deux voies de chaque chemin, le fonctionnement est le suivant : pendant une demi-période $\frac{T}{2}$ du signal d'entrée, le condensateur tournant de chaque chemin, permet d'obtenir, en association avec la résistance commune correspondante, la valeur moyenne du signal d'entrée, ce condensateur mémorise cette valeur moyenne pendant cette demi-période. A la fin de cette demi-période, le potentiel aux bornes du condensateur est égal à $V_1$ par exemple.

. A la demi-période suivante, le condensateur tournant, tout en conservant la valeur moyenne $V_1$ précédemment mémorisée, est inversé. Chacune de ses électrodes est permutée. Ce condensateur permet alors, en association avec la résistance commune correspondante, d'obtenir la valeur moyenne du signal d'entrée pendant la demi-période suivante, en partant de la valeur moyenne $V_1$ précédemment mémorisée, mais inversée ($-V_1$). De cette manière, si un signal d'entrée de période T est appliqué à l'entrée du filtre élémentaire, il est échantillonné à la fréquence limite de SHANNON. Si ce signal est strictement en phase avec les signaux d'échantillonnage, chaque condensateur se charge à la valeur moyenne du signal pendant une demi alternance du signal d'entrée. Si le signal d'entrée est en quadrature avec les signaux d'échantillonnage, la valeur moyenne mémorisée dans les condensateurs tournants est nulle.

D'une manière générale, en disposant N chemins à deux voies en parallèle, chacun de ces chemins échantillonne le signal d'entrée avec une même période d'échantillonnage $\frac{T}{2}$, mais à des instants décalés de $\frac{T}{2N}$.

Le signal filtré, obtenu sur la sortie S à une forme quasi sinusoïdale, avec un nombre 2N de pas par période du signal d'entrée.

Le filtre agit de la même manière que les filtres synchrones puisqu'il favorise les signaux répétitifs synchrones de la fréquence d'échantillonnage et qu'il élimine les signaux de bruit dont la valeur moyenne est alors nulle à toutes ces fréquences. Le signal obtenu est restitué en phase avec le signal d'entrée, lorsque la période d'échantillonnage est égale à la 1/2 période de ce signal d'entrée. Ce filtre présente cependant une différence importante par rapport aux filtres connus à N chemins, puisqu'il ne donne aucune réponse aux harmoniques paires et à la fréquence 0, notamment pour les modes de réalisation des figures 4 et 5. Les harmoniques impaires sont atténuées dans une proportion bien supérieure à celle qui peut être obtenue dans les filtres synchrones de type connu.

Un autre avantage par rapport aux filtres synchrones à N chemins, de type connu, est que dans l'invention, les filtres élémentaires fonctionnent simultanément et non pas l'un après l'autre. Ce fonctionnement simultané permet d'accroître la sensibilité du filtre.

Le filtre qui vient d'être décrit permet d'extraire un signal périodique noyé dans un bruit de fond important, et de restituer le fondamental de ce signal périodique, en phase avec le signal d'entrée. Ce filtre a en outre pour avantage de ne pas introduire de déphasage parasite lorsque la température ambiante varie. Une étude expérimentale de ce filtre montre que le déphasage introduit par des variations de température de 30°C, est inférieur à un milliradian.

Ce filtre peut être entièrement réalisé par intégration de ses composants.

**Revendications**

1. Filtre synchrone à capacités commutées de filtrage reliées en parallèle, comprenant des moyens adaptateurs (1) recevant sur une entrée (E), un signal à filtrer, de période T et fournissant ce signal sur une sortie reliée à des entrées de chemins de filtrage au nombre de N ($P_1$, $P_2$, ..., $P_n$) comportant respectivement des moyens de filtrage ($M_1$, $M_2$, ..., $M_n$) à capacités commutées, ce filtre comprenant en outre des moyens ($I_1$, $I_2$, ..., $I_n$) de commutation des moyens de filtrage, reliés à ces moyens, des moyens sommateurs (3) ayant des entrées respectivement reliées à des sorties des moyens de filtrage ($M_1$, $M_2$, ..., $M_n$) de chaque chemin, pour fournir le signal filtré sur une sortie (S), et des moyens d'échantillonnage (4), reliés aux moyens de commutation ($I_1$, $I_2$, ..., $I_n$) pour leur appliquer des signaux de commande de commutation des moyens de filtrage, caractérisé en ce que les moyens de filtrage ($M_1$, $M_2$, ..., $M_n$) de chaque chemin comportent deux voies identiques ($V_1$, $V_2$) de filtrage par capacité reliées aux moyens de commutation ($I_1$, $I_2$, ..., $I_n$), les signaux de commande de commutation étant symétriques pour les deux voies de chaque chemin, ces signaux étant décalés de $\frac{T}{2N}$ entre deux chemins successifs et ayant respectivement des périodes d'échantillonnage des deux voies d'un chemin, égales à $\frac{T}{2}$.

2. Filtre selon la revendication 1, caractérisé en ce que les deux voies de filtrage de chaque chemin ($P_1$ ou $P_n$) comprennent une résistance (19 ou 22 ou 25) commune dont une borne est reliée à la sortie des moyens adaptateurs (1), les moyens de commutation comprenant un premier et un deuxième commutateur (26, 27) à deux positions, chacune de ces voies comprenant un condensateur (17 ou 18), dont une électrode (28 ou 31) est reliée à une masse de référence, une autre électrode (29) du condensateur (17) d'une première des deux voies étant reliée à une première borne (30) du premier commutateur (26) à deux positions et à une première borne (34) du deuxième commutateur (27) à deux positions, une autre électrode (32) du condensateur d'une deuxième des deux voies étant reliée à une deuxième borne (33) du premier commutateur (26) et à une deuxième borne (35) du deuxième commutateur (27), une borne commune (36) aux deux positions du premier commutateur (26) étant reliée à une autre borne de la résistance commune (19) et une borne commune (37) aux deux positions du deuxième commutateur (27) étant reliée à une entrée correspondante des moyens sommateurs (3), les commutateurs (26, 27) ayant des entrées de commande reliées aux moyens d'échantillonnage (4), pour recevoir lesdits signaux de commande.

3. Filtre selon la revendication 1, caractérisé en ce que les deux voies de filtrage de chaque chemin ($P_1$ ou $P_n$) comprennent une résistance commune (19 ou 22 ou 27) dont une borne est reliée à la sortie des moyens adaptateurs (1), les deux voies de filtrage comprenant un condensateur tournant (40) à deux électrodes (41, 42), au cours de la rotation du condensateur, une première électrode (41) est reliée à une autre borne de la résistance commune (19) et à une entrée correspondante des moyens sommateurs (3), et une deuxième électrode (42) est reliée à une masse de référence, la rotation provoquant ensuite une commutation de ces électrodes pour relier la deuxième électrode (42) avec l'autre borne de la résistance commune (19) et à l'entrée correspondante des moyens sommateurs (3), et pour relier la première électrode (41) avec la masse de référence, les moyens de commutation comportant des moyens (43 ou 44 ou 45) de commande de rotation des condensateurs tournants (40, 46, 47) ces moyens de commande ayant des entrées de commande reliées aux moyens d'échantillonnage (4) pour recevoir lesdits signaux de commande.

4. Filtre selon la revendication 1, caractérisé en ce que les deux voies de chaque chemin ($P_1$ ou $P_n$) comprennent un amplificateur opérationnel (50 ou 51 ou 52) commun à ces deux voies, chaque amplificateur opérationnel ayant une première entrée (56) est reliée à l'autre borne de la résistance commune (19) et une deuxième entrée (57) qui est reliée à une masse de référence, une sortie de cet amplificateur opérationnel étant reliée à une entrée correspondante des moyens sommateurs (3), et un condensateur tournant (53 ou 54 ou 55) à deux électrodes, agencées de manière que, au cours de la rotation du condensateur correspondant (53), une première électrode (58) soit reliée à la première entrée (56) de l'amplificateur opérationnel et une deuxième électrode (59) soit reliée à la sortie de l'amplificateur, la rotation provoquant ensuite une commutation de ces électrodes pour relier la deuxième électrode (59) à la première entrée (56) de l'amplificateur et pour relier la première électrode (58) à la sortie de l'amplificateur, les moyens de commutation comportant des moyens de commande (60 ou 61 ou 62) des condensateurs tournants (53 ou 54 ou 55), ces moyens ayant des entrées de commande reliées aux moyens d'échantillonnage (4) pour recevoir lesdits signaux de commande.

5. Filtre selon l'une quelconque des revendications 2 à 4, caractérisé en ce que ladite résistance commune (19 ou 22 ou 25) est une résistance pure.

6. Filtre selon l'une quelconque des revendications 2 à 4, caractérisé en ce que ladite résistance commune (19 ou 22 ou 25) est une résistance simulée par commutation de capacité (70).

7. Filtre selon la revendication 6, caractérisé en ce que la capacité commutée simulant la résistance commune est un condensateur (70) tournant, fonctionnant à une fréquence supérieure à la fréquence des signaux fournis par les moyens d'échantillonnage (4) qui commandent la commutation des voies des chemins.

## Ansprüche

1. Synchrones Filter mit parallel verbundenen, geschalteten Kapazitäten mit Ankopplungsvorrichtungen (1), die auf einem Eingang (E) ein zu filterndes Signal mit der Periode T empfangen und dieses Signal an einen mit den Eingängen der Filterpfade ($P_1$, $P_2$,... $P_n$) der Anzahl N verbundenen Ausgang abgibt, die Filtervorrichtungen ($M_1$, $M_2$, ... $M_n$) mit geschalteten Kapazitäten aufweisen, wobei dieses Filter außerdem Schaltvorrichtungen ($I_1$, $I_2$,... $I_n$) für die Filtervorrichtungen, die mit diesen Vorrichtungen verbunden sind, Addiervorrichtungen (3) mit Eingängen, die jeweils mit Ausgängen der Filtervorrichtungen ($M_1$, $M_2$, ... $M_n$) jedes Pfads verbunden sind, um ein gefiltertes Signal auf einem Ausgang (S) abzugeben, und Takt-Signalvorrichtungen (4) aufweist, die mit den Schaltvorrichtungen ($I_1$, $I_2$, ... $I_n$) verbunden sind, um auf diese Steuersignale zum Schalten der Filtervorrichtungen anzuwenden, dadurch gekennzeichnet, daß die Filtervorrichtungen ($M_1$, $M_2$, ... $M_n$) jedes Pfads zwei identische Kapazitätsfilterwege ($V_1$, $V_2$) aufweisen, die mit den Schaltvorrichtungen ($I_1$, $I_2$, ... $I_n$) verbunden sind, wobei die Schaltsignale für die beiden Wege jedes Pfads identisch sind, wobei diese Signal um T/2N zwischen zwei aufeinander folgenden Pfade versetzt sind und Taktperioden für die zwei Wege eines Pfads von T/2 besitzen.

2. Filter nach Anspruch 1, dadurch gekennzeichnet, daß die beilden Filterwege jedes Pfads ($P_1$ oder $P_n$) einen gemeinsamen Widerstand (19 oder 22 oder 25) aufweisen, von dem ein Anschluß mit den Ankoppelungs vorrichtungen (1) verbunden ist, wobei die Schaltvorrichtungen einen ersten und einen zweiten Schalter (26, 27) mit zwei Stellungen umfassen, wobei jeder dieser Wege einen Kondensator (17 oder 18) umfaßt, von dem eine Elektrode (28 oder 31) mit einer Referenzmasse verbunden ist, wobei eine andere Elektrode (29) des Kondensators (17) eines ersten der beiden Wege mit einem ersten Anschluß (30) des ersten Schalters (26) mit zwei Stellungen und mit einem ersten Anschluß (34) des zweiten Schalters (27) mit zwei Stellungen verbunden ist, wobei eine andere Elektrode (32) des Kondensators eines zweiten der beiden Wege mit einem zweiten Anschluß (33) des ersten Schalters (26) und einem zweiten Anschluß (35) des zweiten Schalters (27) verbunden ist, wobei ein gemeinsamer Anschluß (36) mit zwei Stellungen des ersten Schalter (26) mit einem anderen Anschluß des gemeinsamen Widerstands (19) und ein gemeinsamer Anschluß (37) mit zwei Stellungen des zweiten Schalters (27) mit einem entsprechenden Eingang der Addiervorrichtungen verbunden sind, wobei die Schalter (26, 27) Steuereingänge besitzen, die mit den Takt-Signalvorrichtungen (4) verbunden sind, um die Steuersignale zu empfangen.

3. Filter nach Anspruch 1, dadurch gekennzeichnet, daß die beiden Filterwege jedes Pfads (P₁ oder Pₙ) einen gemeinsamen Widerstand (19 oder 22 oder 25) aufweisen, von dem ein Anschluß mit den Ankopelungsvorrichtungen (1) verbunden ist, wobei die beiden Filterwege einen Drehkondensator (40) mit zwei Elektroden (41, 42) im Drehverlauf des Kondensators umfassen, wobei eine erste Elektrode (41) mit einem anderen Anschluß des gemeinsamen Widerstands (19) und mit einem entsprechenden Anschluß der Addiervorrichtungen (3) verbunden ist und eine zweite Elektrode (42) mit einer Referenzmasse verbunden ist, wobei die Drehung nachfolgend ein Schalten dieser Elektroden bewirkt, um die zweite Elektrode (42) mit dem anderen Anschluß des gemeinsamen Widerstands (19) und dem entsprechenden Eingang der Addiervorrichtungen (3) zu verbinden und die erste Elektrode (41) mit der Referenzmasse zu verbinden, wobei die Schaltvorrichtungen Steuervorrichtungen (43 oder 44 oder 45) zum Steuern der Drehung der Drehkondensatoren (40, 46, 47) umfaßt, wobei diese Steuervorrichtungen mit den Takt-Signalvorrichtungen (4) verbundene Steuereingänge zum Erhalt der Steuersignale besitzen.

4. Filter nach Anspruch 1, dadurch gekennzeichnet, daß die beiden Wege jedes Pfads (P₁ oder Pₙ) aufweisen : einen für diese beiden Wege gemeinsamen Operationsverstärker, wobei jeder Operationsverstärker einen ersten Eingang (56), der mit dem anderen Anschluß des gemeinsamen Widerstands (19) verbunden ist, und einen zweiten Eingang (57), der mit einer Referenzmasse verbunden ist, besitzt, wobei ein Ausgang dieses Operationsverstärkers mit einem entsprechenden Eingang der Addiervorrichtungen (3) verbunden ist ; und einen Drehkondensator (53 oder 54 oder 55) mit zwei Elektroden, die so angeordnet sind, daß während der Drehung des entsprechenden Kondensators (53) eine erste Elektrode (58) mit dem ersten Eingang (56) des Operationsverstärkers und eine zweite Elektrode (59) mit dem Ausgang des Verstärkers verbunden ist, wobei die Drehung nachfolgend ein Schalten dieser Elektroden verursacht, um die zweite Elektrode (59) mit dem ersten Eingang (56) des Verstärkers und die erste Elektrode (58) mit dem Ausgang des Verstärkers zu verbinden, wobei die Schaltvorrichtungen Steuervorrichtungen (60 oder 61 oder 62) für die Drehkondensatoren (53 oder 54 oder 55) aufweist, wobei diese Vorrichtungen mit den Takt-Signalvorrichtungen (4) verbundene Steuereingänge zum Erhalt der Steuersignale besitzen.

5. Filter nach einem der Ansprüche 2 bis 4, dadurch gekennzeichnet, daß der gemeinsame Widerstand (19 oder 22 oder 25) ein reiner Widerstand ist.

6. Filter nach einem der Ansprüche 2 bis 4, dadurch gekennzeichnet, daß der gemeinsame Widerstand (19 oder 22 oder 25) ein durch das Schalten der Kapazität (70) simulierter Widerstand ist.

7. Filter nach Anspruch 6, dadurch gekennzeichnet, daß die geschaltete Kapazität, die den gemeinsamen Widerstand simuliert, ein Drehkondensator (70) ist, der bei einer Frequenz arbeitet, die höher ist als die Frequenz der Signale, die vor den Takt-Signalvorrichtungen (4), die das Schalten der Wege der Pfade steuern, erzeugt werden.

## Claims

1. Synchronous filter with switched filtering capacitances connected in parallel, comprising matching means (1) receiving on one input (E) a signal to be filtered of cycle T and supplying said signal to an output connected to inputs of filtering paths in the number N ($P_1$, $P_2$, ..... $P_n$) the latter respectively having filtering means ($M_1$, $M_2$ .... $M_n$) with switched capacitances, said filter also comprising means ($I_1$, $I_2$ .... $I_n$) for switching the filtering means and connected to the latter, summating means (3) having inputs respectively connected to outputs of the filtering means ($M_1$, $M_2$ .... $M_n$) of eath path for supplying the filtered signal to an output (S), and sampling means (4) connected to the switching means ($I_1$, $I_2$ .... $I_n$) in order to apply thereto switching control signals from the filtering means, characterized in that the filtering means ($M_1$, $M_2$ .... $M_n$) of each path comprise two identical filtering channels ($V_1$, $V_2$) per capacitance connected to the switching means ($I_1$, $I_2$ .... $I_n$), the switching control signals being symmetrical for the two channels of each path, said signals being phase displaced by $\frac{T}{2N}$ between two successive paths and respectively having sampling periods or cycles of the two channels of a path equal to $\frac{2}{T}$.

2. Filter according to claim 1, characterized in that the two filtering channels of each path ($P_1$ or $P_n$) comprise a common resistor (19 or 22 or 25), whereof one terminal is connected to the output of matching means (1), the swicth means comprising first and second two-position switches (26, 27), each of these channels comprising a capacitor (17 or 18), whereof one electrode (28 or 31) is connected to reference earth, another electrode (24) of the capacitor (17) of a first of the two channels being connected to the first terminal (30) of the first two-position switch (26) and to a first terminal (34) of the second two-position switch (27), another electrode (32) of the capacitor of a second of the two channels being connected to a second terminal (33) of the first switch (26) and to a second terminal (35) of the second switch (27), a terminal (36) common to the two positions of the first switch (26) being connected to another terminal of the common resistor (19) and a terminal (37) common to the two positions of the first switch is connected to a corresponding input of the summating means (3), the switches (26, 27) having control inputs connected to the sampling means (4) for receiving said control signals.

3. Filter according to claim 1, characterized in that the two filtering channels of each path ($P_1$ or $P_n$) comprise a common resistor (19 or 22 or 27), whereof one terminal is connected to the output of the matching means (1), the two filtering channels, comprising a rotary capacitor (40) with two electrodes (41, 42), during the rotation of the capacitor a first electrode (41) is connected to another terminal of the common resistor (19) and to a corresponding input of the summating means (3) and a second electrode (42) is connected to a reference earth, the rotation then bringing about a switching of these electrodes to connect the second electrode (42) to the other terminal of the resistor (14) and the corresponding input of the summating means (3) and for connecting the first electrode (41) to the reference earth, the switching means having rotation control means (43 or 44 or 45) for the rotary capacitors (40, 46, 47) with control inputs connected to the sampling means (4) for receiving said control signals.

4. Filter according to claim 1, characterized in that the two filtering channels of eath path ($P_1$ or $P_n$) comprise an operational amplifier (50 or 51 or 52) common to these two channels, whereof a first input (56) is connected to the other terminal of the common resistor (19) and whereof a second input (57) is connected to a reference earth, an output of said operational amplifier being connected to a corresponding input of the summating means (3) and a rotary capacitor (53 or 54 or 55) with two electrodes, during the rotation of said capacitor (53) a first electrode (58) is connected to the first input (56) of the operational amplifier and a second electrode (59) is connected to the output of the amplifier, rotation then bringing about a switching of these electrodes to connect the second electrode (59) to the first input (56) of the amplifier and the first electrode (58) to the output of the amplifier, the switching means having rotation control means (60 or 61 or 62) of the rotary capacitors (53 or 54 or 55) with control inputs connected to the sampling means (4) for receiving said control signals.

5. Filter according to any one of the claims 2 to 4, characterized in that the common resistor (19 or 22 or 25) is a pure resistor.

6. Filter according to any one of the claims 2 to 4, characterized in that said common resistor (19 or 22 or 25) is a resistor simulated by capacitante switching (70).

7. Filter according to claim 6, characterized in that the switched capacitance simulating the common resistor is a rotary capacitor (70) operating at a frequency above the frequency of the signals supplied by the sampling means (4) controlling the switching of the channels of the paths.

# FIG.1

# FIG.2

FIG.3

# FIG. 4

# FIG. 5

# FIG. 6